# FASCICULE DE BREVET EUROPEEN

(11) **EP 4 339 952 B1**
(45) Date de publication et mention de la délivrance du brevet: **04.03.2026**
(21) Numéro de dépôt: 23197246.4
(22) Date de dépôt: 13.09.2023
(51) Int. Cl.: G11C 13/00, H10B 63/00, H10N 70/20, H10N 70/00

(54) **CELLULE MÉMOIRE À CHANGEMENT DE PHASE**
PHASENWECHSELSPEICHERZELLE
PHASE CHANGE MEMORY CELL

(30) Priorité: 15.09.2022 FR 2209301
(43) Date de publication de la demande: 20.03.2024
(73) Titulaire: Commissariat à l'Energie Atomique et aux Energies Alternatives, 75015 Paris (FR)
(72) Inventeur: NAVARRO, Gabriele, 38054 Grenoble Cedex 09 (FR); BOURGEOIS, Guillaume, 38054 Grenoble Cedex 09 (FR); CYRILLE, Marie-Claire, 38054 Grenoble Cedex 09 (FR)
(74) Mandataire: Cabinet Beaumont

(56) Documents cités:
- EP-A1- 3 483 889
- SERRA ANNA LISA ET AL: "Phase-change memory electro-thermal analysis and engineering thanks to enhanced thermal confinement", SOLID STATE ELECTRONICS, ELSEVIER SCIENCE PUBLISHERS, BARKING, GB, vol. 186, 9 June 2021 (2021-06-09), XP086859724, ISSN: 0038-1101, [retrieved on 20210609], DOI: 10.1016/J.SSE.2021.108111

## Description

### Domaine technique

La présente description concerne de façon générale les dispositifs électroniques, et plus particulièrement les dispositifs mémoire comportant des cellules mémoire à base d'un matériau à changement de phase, également appelées cellules mémoire à changement de phase.

### Technique antérieure

Dans une cellule mémoire à changement de phase, le matériau à changement de phase est capable d'alterner, sous l'effet de la chaleur, entre une phase cristalline, électriquement conductrice, et une phase amorphe, électriquement isolante. Les phases cristalline et amorphe du matériau à changement de phase d'une cellule mémoire permettent de définir, pour cette cellule, deux états mémoire correspondant par exemple respectivement aux valeurs logiques 1 et 0. La chaleur nécessaire au changement de phase est en général produite par effet Joule, par exemple au moyen d'un élément chauffant situé à proximité du matériau à changement de phase et parcouru par un courant électrique résultant d'une impulsion de tension appliquée entre des bornes de conduction de l'élément chauffant.

Le document EP 3483889 décrit une puce à mémoire non volatile embarquée à matériau à changement de phase.

### Résumé de l'invention

Afin d'obtenir des cellules mémoire à changement de phase présentant une efficacité énergétique accrue, il serait souhaitable d'optimiser les performances thermiques des cellules mémoire à changement de phase actuelles, de sorte que l'énergie électrique requise pour échauffer le matériau à changement de phase soit la plus faible possible. De façon avantageuse, cela permettrait à des dispositifs mémoire intégrant de telles cellules de présenter une consommation énergétique moindre que les dispositifs mémoire à changement de phase actuels.

Un mode de réalisation pallie tout ou partie des inconvénients des cellules mémoire à base d'un matériau à changement de phase connues et des dispositifs mémoire connus intégrant de telles cellules.

L'invention est définie par la revendication 1. Les revendications dépendantes couvrent des modes de réalisation et variantes de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figure 1A et figure 1B sont des vues en coupe illustrant, de façon schématique et partielle, un exemple d'un dispositif mémoire comprenant des cellules mémoire à base d'un matériau à changement de phase ;

les figure 2A, figure 2B, figure 2C, figure 2D, figure 2E, figure 2F, figure 2G, figure 2H et figure 2I sont des vues en coupe illustrant, de façon schématique et partielle, un procédé de fabrication d'un dispositif mémoire comprenant des cellules mémoire à base d'un matériau à changement de phase selon un mode de réalisation ; et

les figure 3A et figure 3B sont des vues en coupe illustrant, de façon schématique et partielle, un dispositif mémoire comprenant des cellules mémoire à base d'un matériau à changement de phase selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les éléments et circuits de commande des cellules mémoire à changement de phase des dispositifs mémoire décrits, pouvant notamment inclure des éléments de sélection et de connexion électrique, ne sont pas détaillés, les modes de réalisation décrits étant compatibles avec les éléments et circuits de commande de cellules mémoire à changement de phase usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

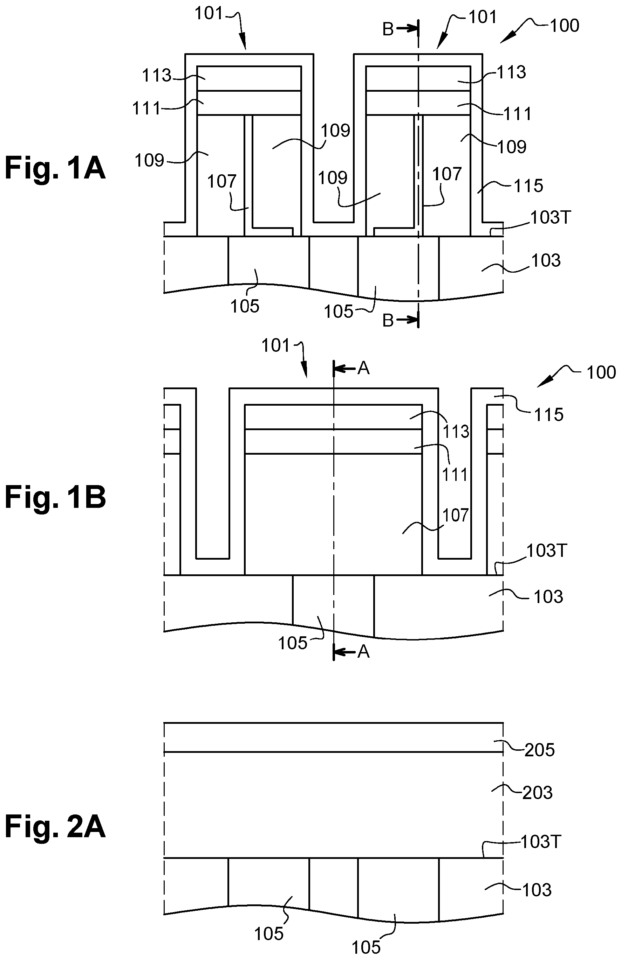

Les figure 1A et figure 1B sont des vues en coupe, respectivement selon le plan AA de la figure 1B et selon le plan BB de la figure 1A, illustrant, de façon schématique et partielle, un exemple d'un dispositif mémoire 100 comprenant des cellules mémoire 101 à base d'un matériau à changement de phase, ou cellules mémoire à changement de phase 101. Le plan AA de la figure 1B est sensiblement orthogonal au plan BB de la figure 1A.

À titre d'exemple, le dispositif mémoire 100 est une mémoire non volatile, par exemple une mémoire EEPROM (de l'anglais « Electrically Erasable Programmable Read-Only Memory » - mémoire à lecture seule programmable et effaçable électriquement). La programmation de chaque cellule mémoire 101 du dispositif mémoire 100 est par exemple effectuée à l'issue de la fabrication du dispositif 100 et peut ensuite être modifiée plusieurs fois pendant son utilisation.

Dans l'exemple représenté, les cellules mémoire 101 sont formées dans et sur un substrat 103, par exemple une plaquette ou un morceau de plaquette en un matériau semiconducteur, par exemple le silicium.

Dans l'exemple illustré, chaque cellule mémoire 101 comporte un élément de reprise de contact 105, par exemple un via conducteur, formé dans le substrat 103. L'élément de reprise de contact 105 s'étend dans l'épaisseur du substrat 103 depuis une face 103T du substrat 103 (la face supérieure du substrat 103, dans l'orientation des figures 1A et 1B). À titre d'exemple, l'élément de reprise de contact 105 est en un matériau électriquement conducteur, par exemple un métal, par exemple le cuivre (Cu) ou le tungstène (W), ou un alliage métallique, par exemple le nitrure de titane (TiN) ou le nitrure de tantale (TaN).

Dans l'exemple représenté, chaque cellule mémoire 101 comporte en outre un élément chauffant résistif 107 situé sur et en contact avec l'élément de reprise de contact 105 de la cellule. Dans cet exemple, l'élément chauffant 107 présente une forme générale en L comprenant une partie horizontale, s'étendant latéralement sur et en contact avec la face supérieure de l'élément de reprise de contact 105 sous-jacent, et une partie verticale, s'étendant depuis une extrémité de la partie horizontale le long d'une direction sensiblement orthogonale à la face 103T du substrat 103. L'élément chauffant 107 est en un matériau électriquement conducteur. À titre d'exemple, l'élément chauffant est en un métal ou en un alliage métallique.

Dans l'exemple illustré, l'élément chauffant 107 de chaque cellule 101 est interposé latéralement entre deux régions électriquement et thermiquement isolantes 109. Plus précisément, dans cet exemple, les régions isolantes 109 revêtent toutes les faces latérales de l'élément chauffant 107 parallèles au plan BB de la figure 1A ainsi que la face de la partie horizontale de l'élément chauffant 107 opposée à la face 103T du substrat 103. Dans l'orientation des figures 1A et 1B, les faces supérieures des régions isolantes 109 affleurent la face supérieure de la partie verticale de l'élément chauffant 107. À titre d'exemple, la région isolante 109 est en nitrure de silicium (SiN).

Dans l'exemple représenté, chaque cellule mémoire 101 comprend en outre une région en un matériau à changement de phase 111. Dans l'orientation des figures 1A et 1B, la région en matériau à changement de phase 111 revêt les faces supérieures des régions isolantes 109 et de la partie verticale de l'élément chauffant 107 de la cellule. À titre d'exemple, la région 111 est en un matériau dit « chalcogénure », c'est-à-dire un matériau ou un alliage comprenant au moins un élément chalcogène, par exemple un matériau de la famille du tellurure de germanium (GeTe) ou du germanium-antimoine-tellure (GeSbTe, également désigné par l'acronyme « GST »).

Dans l'exemple illustré en figures 1A et 1B, la face supérieure de la région en matériau à changement de phase 111, autrement dit la face de la région 111 opposée au substrat 103, est revêtue d'une région électriquement conductrice 113. À titre d'exemple, la région électriquement conductrice 113 est en un métal ou en un alliage métallique, par exemple le nitrure de titane (TiN).

Bien que cela n'ait pas été illustré en figures 1A et 1B, la région électriquement conductrice 113 peut être revêtue, du côté de sa face opposée à la région en matériau à changement de phase 111, d'une région diélectrique destinée à confiner la chaleur à l'intérieur de la cellule 101.

Dans l'exemple représenté, chaque cellule 101 comporte en outre une couche d'encapsulation 115 revêtant les flancs de l'empilement constitué par les régions isolantes 109, la région en matériau à changement de phase 111 et la région électriquement conductrice 113. La couche d'encapsulation 115 revêt plus précisément les faces latérales des régions isolantes 109, les faces latérales de la région en matériau à changement de phase 111, et les faces latérales et la face supérieure de la région conductrice 113. Dans l'exemple illustré, la couche d'encapsulation 115 revêt en outre les faces latérales de l'élément chauffant 107 parallèles au plan de la figure 1A, non revêtues par les régions isolantes 109. La couche d'encapsulation 115 peut par ailleurs, comme dans l'exemple illustré en figures 1A et 1B, se prolonger entre les cellules mémoire 101. Plus précisément, dans cet exemple, la couche d'encapsulation 115 revêt des parties de la face 103T du substrat 103 qui ne sont revêtues ni par les régions isolantes 109, ni par l'élément chauffant 107.

Bien que cela n'ait pas été détaillé sur les figures, les cellules mémoire 101 du dispositif 100 sont par exemple agencées en matrice. Plus précisément, le dispositif 100 peut par exemple comprendre des premières lignes, appelées lignes de bits (« bit line » en anglais), correspondant à des rangées de cellules mémoires 101 parallèles entre elles et s'étendant le long d'une direction orthogonale au plan de la figure 1B, et des deuxièmes lignes, appelées lignes de mots (« word line », en anglais), correspondant à des rangées de cellules mémoire 101 parallèles entre elles et orthogonales aux lignes de bits.

Bien que cela n'ait pas été détaillé en figures 1A et 1B, l'élément de reprise de contact 105 de chaque cellule mémoire 101 traverse par exemple le substrat 103 et permet de connecter la partie horizontale de l'élément chauffant 107 sus-jacent à une borne de conduction d'un élément de sélection, non représenté, par exemple un transistor MOS (de l'anglais « Metal-Oxide-Semiconductor » - Métal-oxyde-semiconducteur), situé du côté d'une face du substrat 103 opposée à la face 103T. Le transistor de sélection, ou sélecteur, permet de sélectionner individuellement chaque cellule mémoire 101 du dispositif 100. À titre d'exemple, les transistors de sélection comprennent chacun une autre borne de conduction connectée à un nœud d'application d'un potentiel de référence, par exemple la masse, et une borne de commande (grille) sur laquelle est appliquée une tension de commande destinée, selon sa valeur, à permettre ou à empêcher une circulation de courant entre les bornes de conduction (source et drain) du transistor. Les transistors de sélection des cellules mémoire 101 faisant partie d'une même ligne de mot comportent par exemple une grille commune, s'étendant par exemple le long d'une direction orthogonale au plan de la figure 1A.

En outre, toutes les cellules mémoire faisant partie d'une même ligne de bit sont par exemple interconnectées, par leurs régions conductrices 113, au moyen d'une électrode commune non représentée en figures 1A et 1B.

Les cellules mémoire 101 de la matrice du dispositif mémoire 100 peuvent stocker des données en modifiant la phase du matériau constitutif de leurs régions 111 respectives. De manière générale, les matériaux à changement de phase sont des matériaux capables d'alterner, sous l'effet d'une variation de température, entre une phase cristalline et une phase amorphe, la phase amorphe présentant une résistance électrique supérieure à celle de la phase cristalline. Dans le cas des cellules mémoire 101, ce phénomène est mis à profit pour obtenir un état passant, permettant une circulation d'un courant entre l'élément de reprise de contact 105 et la région conductrice 113, lorsque le matériau de la région 111 est dans la phase cristalline, et un état bloqué, empêchant la circulation d'un courant entre l'élément de reprise de contact 105 et la région conductrice 113, lorsqu'une partie au moins du matériau de la région 111 est dans la phase amorphe. Dans la présente description, on considère pour simplifier que toute la région 111 subit les changements de phase. Toutefois, en pratique, les changements de phase peuvent s'opérer dans une partie seulement de la région 111, par exemple située sur et en contact avec la face supérieure de l'élément chauffant 107.

Les états passant (région 111 en phase cristalline) et bloqué (région 111 en phase amorphe) de chaque cellule mémoire 101 correspondent par exemple respectivement à des valeurs logiques 1 et 0. Lors des commutations de la cellule 101 entre les états logiques 1 et 0, l'élément de reprise de contact 105 et la région conductrice 113 sont par exemple soumis à une impulsion de tension de commande provoquant une circulation de courant à travers l'élément chauffant 107. Ce courant entraîne, par effet Joule puis par rayonnement et/ou conduction à l'intérieur de la structure de la cellule 101, une élévation de température de la région 111 depuis sa face inférieure, située en regard de l'élément chauffant 107.

Plus précisément, pour faire basculer la cellule mémoire depuis l'état logique 1 vers l'état logique 0, on chauffe la région 111 au moyen de l'élément chauffant 107, par exemple à une température T1 et pendant une durée d1. La température T1 et la durée d1 sont choisies de sorte à provoquer un changement de phase du matériau de la région 111 depuis la phase cristalline vers la phase amorphe. La température T1 est par exemple supérieure à la température de fusion du matériau à changement de phase. À titre d'exemple, la température T1 est comprise entre 600 et 1 000 °C et la durée d1 est inférieure à 500 ns.

À l'inverse, pour faire basculer la cellule mémoire 101 depuis l'état logique 0 vers l'état logique 1, on chauffe la région 111 au moyen de l'élément chauffant 107, par exemple à une température T2 inférieure à la température T1 et pendant une durée d2 supérieure à la durée d1. La température T2 et la durée d2 sont choisies de sorte à provoquer un changement de phase du matériau de la région 111 depuis la phase amorphe vers la phase cristalline. La température T2 est par exemple supérieure à une température de fusion du matériau de la région 111. À titre d'exemple, la température T2 est sensiblement égale à la température T1 et la durée d2 est inférieure à 1 µs.

Après fabrication du dispositif mémoire 100 et avant que des opérations d'écriture, ou de programmation, ne soient mises en œuvre, la région en matériau à changement de phase 111 de chaque cellule mémoire 101 est par exemple dans une phase cristalline. En d'autres termes, le dispositif mémoire 100 se trouve, avant écriture, dans un état initial où toutes ses cellules 101 contiennent la même valeur logique (la valeur 1, dans cet exemple). Des opérations de stockage de données peuvent ensuite être réalisées dans le dispositif mémoire 100, en opérant un changement de phase des régions 111 d'une partie des cellules mémoire 101 depuis la phase cristalline vers la phase amorphe, correspondant dans cet exemple à une valeur logique 0, tandis que les régions 111 de l'autre partie des cellules 101 sont maintenues dans leur état initial, autrement dit dans la phase cristalline correspondant dans cet exemple à la valeur logique 1.

Pour lire l'une des cellules mémoire à changement de phase 101 du dispositif 100, la cellule est sélectionnée en polarisant la grille du transistor de sélection associé. Une circulation d'un courant, présentant une valeur suffisamment faible pour éviter tout changement de phase involontaire, est ensuite provoquée dans la cellule 101 en appliquant une différence de potentiel entre la région conductrice 113 et l'élément de reprise de contact 105. Une résistance électrique, entre la région conductrice 113 et l'élément de reprise de contact 105, peut alors être mesurée. Cette résistance électrique reflète la valeur logique, 0 ou 1, précédemment mémorisée dans la cellule mémoire 101.

Bien que cela n'ait pas été détaillé en figures 1A et 1B, le dispositif 100 peut comprendre d'autres couches, par exemple des couches en matériaux diélectriques, disposées du côté de la face 103T du substrat 103.

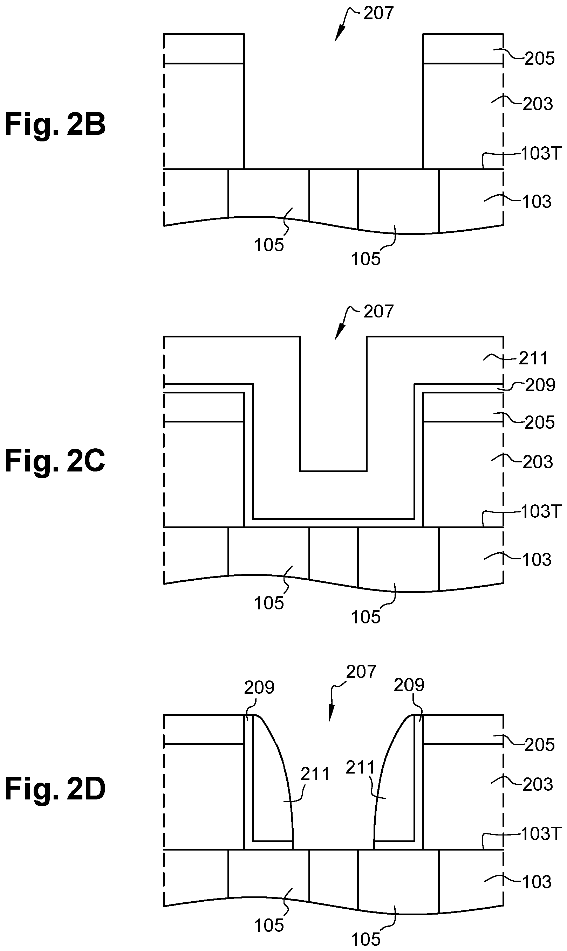

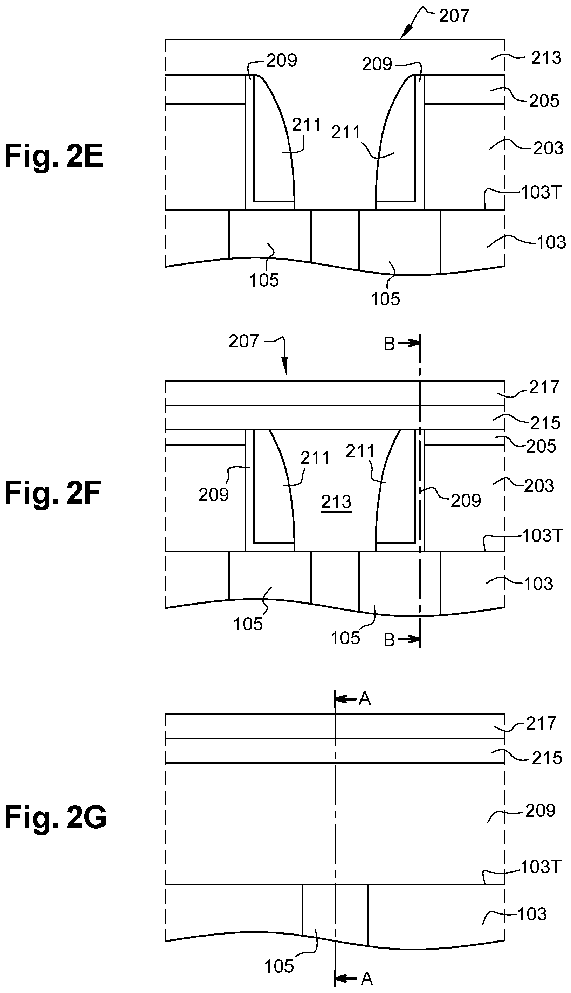

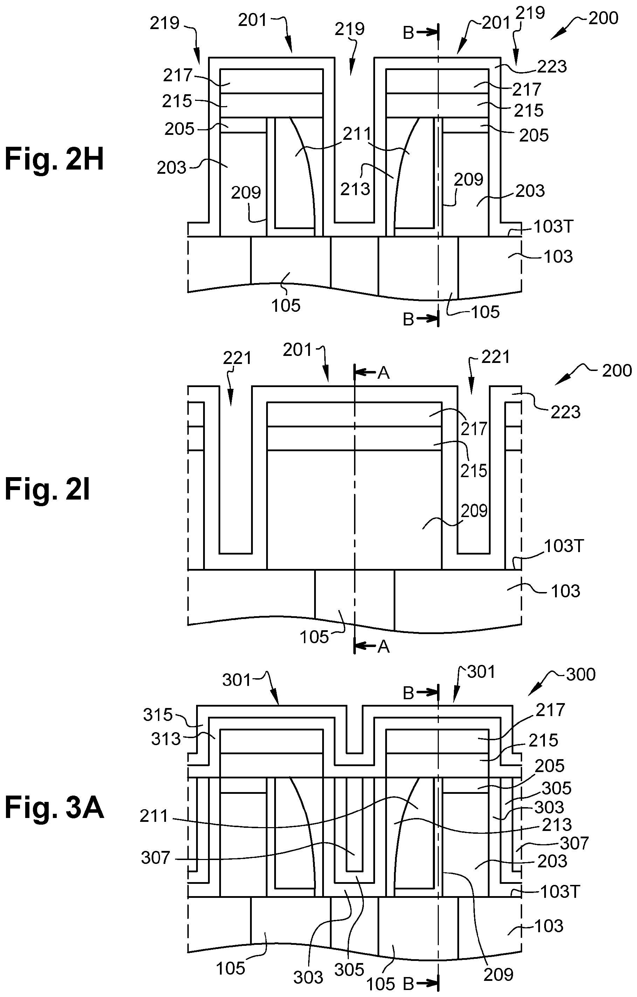

Les figure 2A, figure 2B, figure 2C, figure 2D, figure 2E, figure 2F, figure 2G, figure 2H et figure 2I sont des vues en coupe illustrant, de façon schématique et partielle, des étapes successives d'un procédé de fabrication d'un dispositif mémoire 200 comprenant des cellules mémoire 201 à base d'un matériau à changement de phase selon un mode de réalisation.

Le dispositif mémoire 200 des figures 2A à 2I comprend des éléments en commun avec le dispositif mémoire 100 des figures 1A et 1B. Ces éléments communs ne seront pas décrits à nouveau ci-après.

La figure 2A est une vue en coupe illustrant plus précisément une structure obtenue à l'issue d'une étape de dépôt, du côté de la face 103T du substrat 103, d'un empilement de couches thermiquement isolantes 203 et 205. Dans l'exemple représenté, la couche isolante 203 revêt la face supérieure 103T du substrat 103 et la face supérieure des éléments de reprise de contact 105 qui affleurent la face 103T. Dans cet exemple, la couche isolante 205 revêt la face de la couche isolante 203 opposée au substrat 103 (la face supérieure de la couche isolante 203, dans l'orientation de la figure 2A).

Selon un mode de réalisation, la couche isolante 203 est en un matériau présentant une densité, ou une masse volumique, inférieure à celle du matériau de la couche isolante 205. La couche isolante 203 est par exemple en carbure de silicium (SiC) ou en carbonitrure de silicium (SiCN) .

La couche isolante 205 est par exemple en nitrure de silicium (SiN), en carbonitrure de silicium, en nitrure de germanium (GeN), en nitrure de carbone (CN) ou en carbone (C). À titre de variante, les couches isolantes 203 et 205 sont toutes deux en carbure de silicium (SiC) ou en nitrure de silicium (SiN), et la couche isolante 205 présente une densité, ou une masse volumique, supérieure à celle de la couche isolante 203. Dans ce cas, la couche 203 présente par exemple une masse volumique comprise entre 0,5 et 1,5 g/cm³ et la couche 205 présente par exemple une masse volumique supérieure à 2 g/cm³. À titre d'exemple, la couche isolante 203 présente une épaisseur comprise entre 50 nm et 150 nm, par exemple égale à environ 80 nm, et la couche isolante 205 présente une épaisseur comprise entre 5 nm et 50 nm, par exemple égale à environ 20 nm.

Les couches 203 et 205 sont par exemple toutes deux électriquement isolantes.

La figure 2B est une vue en coupe illustrant une structure obtenue à l'issue d'une étape de formation de tranchées 207 dans les couches isolantes 203 et 205. À des fins de simplification, une seule tranchée 207 est représentée en figure 2B.

Dans l'exemple représenté, la tranchée 207 s'étend depuis la face supérieure de la couche 205 jusqu'à la face 103T du substrat 103 en traversant totalement les couches 203 et 205. Dans cet exemple, des parties des faces supérieures de deux éléments de reprise de contact 105 adjacents ainsi qu'une partie de la face 103T du substrat 103 située entre les deux éléments de reprise de contact 105 sont exposées au fond de la tranchée 207.

Les tranchées 207 sont par exemple sensiblement parallèles entre elles et s'étendent le long d'une direction sensiblement orthogonale au plan de la figure 2B. Les tranchées 207 séparent latéralement des parties disjointes des couches 203 et 205. Dans cet exemple, les parties des couches 203 et 205 séparées par les tranchées 207 sont sensiblement parallèles entre elles et s'étendent le long d'une direction sensiblement orthogonale au plan de la figure 2B.

À titre d'exemple, les tranchées 207 sont formées par photolithographie puis gravure.

La figure 2C est une vue en coupe illustrant une structure obtenue à l'issue d'une étape de dépôt, du côté de la face 103T du substrat 103, d'une couche électriquement conductrice 209 revêtue d'une couche électriquement isolante 211.

Dans l'exemple représenté, la couche électriquement conductrice 209 revêt les parois et le fond des tranchées 207 et s'étend latéralement sur et en contact avec la face supérieure de la couche 205. Plus précisément, dans cet exemple, la couche électriquement conductrice 209 revêt les flancs et la face supérieure des parties de la couche 205 subsistant à l'issue de la formation des tranchées 207, les flancs des parties de la couche 203 subsistant à l'issue de la formation des tranchées 207, et les parties des faces supérieures des éléments de reprise de contact 105 et de la face 103T du substrat 103 préalablement exposées au fond des tranchées 207. La couche isolante 211 revêt la face de la couche conductrice 209 opposée au substrat 103 (la face supérieure de la couche conductrice 209, dans l'orientation de la figure 2C).

À titre d'exemple, la couche conductrice 209 présente une épaisseur comprise entre 1 nm et 20 nm, par exemple égale à environ 3 nm, et la couche isolante 211 présente une épaisseur comprise entre 5 nm et 100 nm, par exemple égale à environ 20 nm.

Dans l'exemple illustré en figure 2C, les couches 209 et 211 ne comblent pas, c'est-à-dire ne remplissent pas intégralement, la tranchée 207. Cet exemple n'est toutefois pas limitatif, l'empilement formé par les couches 209 et 211 pouvant combler la tranchée 207.

À titre d'exemple, la couche conductrice 209 est en un métal ou en un alliage métallique, par exemple le nitrure de titane (TiN), le nitrure de tantale (TaN), le carbonitrure de titane (TiCN) ou le nitrure de silicium-titane (TiSiN).

À titre d'exemple, la couche isolante 211 est en nitrure de silicium (SiN) ou en carbure de silicium (SiC).

La figure 2D est une vue en coupe illustrant une structure obtenue à l'issue d'une étape de gravure anisotrope des couches 209 et 211. Plus précisément, dans l'exemple représenté, la vitesse de gravure des couches 209 et 211 est plus importante le long d'une direction orthogonale à la face 103T du substrat 103 que dans des directions parallèles à la face 103T.

Dans l'exemple illustré en figure 2D, les parties des couches 209 et 211 situées à l'aplomb des parties des couches 203 et 205, autrement dit les parties des couches 209 et 211 non situées à l'intérieur des tranchées 207, sont éliminées. En figure 2D, il subsiste, à l'intérieur de chaque tranchée 207, deux parties disjointes de la couche conductrice 209 revêtant des flancs opposés et se prolongeant sur des parties opposées du fond de la tranchée 207. Chaque partie de la couche conductrice 209 présente une forme générale en L, dont une partie horizontale revêt au moins en partie la face supérieure de l'un des éléments de reprise de contact 105 et dont une partie verticale revêt les flancs des parties des couches isolantes 203 et 205 situées à proximité de l'élément de reprise de contact 105.

Chaque partie en forme de L de la couche conductrice 209 correspond à un élément chauffant d'une cellule mémoire 201 du dispositif 200, par exemple identique ou analogue aux éléments chauffants 107 des cellules 101 du dispositif 100 précédemment décrit en relation avec les figures 1A et 1B.

Il subsiste en outre, dans l'exemple illustré, des parties disjointes de la couche isolante 211 situées à l'intérieur des L formés par les parties de la couche 209. Chaque partie de la couche isolante 211 revêt plus précisément la face supérieure de partie horizontale du L formé par la partie de la couche 209, et la face de la partie verticale du L tournée du côté de la partie horizontale du L. Dans l'exemple représenté, les parties de la couche isolante 211 présentent une forme évasée. Plus précisément, chaque partie de la couche isolante 211 est plus large au voisinage de la partie horizontale du L formé par la partie de la couche 209 associée qu'au voisinage de l'extrémité de la partie verticale du L opposée à la partie horizontale.

La figure 2E est une vue en coupe illustrant une structure obtenue à l'issue d'une étape de dépôt, du côté de la face 103T du substrat 103, d'une couche électriquement et thermiquement isolante 213.

Dans l'exemple représenté, la couche isolante 213 comble les tranchées 207 et revêt la face supérieure des parties de la couche 205 préalablement exposées à l'issue de l'étape de gravure anisotrope. Dans l'exemple illustré, la couche isolante 213 revêt en outre les faces libres des parties des couches 209 et 211 subsistant à l'issue de l'étape de gravure anisotrope, ainsi que les parties de la face 103T du substrat 103 et les parties des faces supérieures des éléments de reprise de contact 105 préalablement exposées à l'issue de l'étape de gravure anisotrope.

La couche isolante 213 est par exemple en le même matériau que la couche isolante 203, par exemple en carbure de silicium (SiC). À titre de variante, la couche 213 est en un matériau différent du matériau de la couche 203, par exemple en dioxyde de silicium (SiO₂).

La figure 2F et la figure 2G sont des vues en coupe, respectivement selon le plan AA de la figure 2G et selon le plan BB de la figure 2F, illustrant une structure obtenue à l'issue d'une étape d'amincissement de la couche isolante 213 puis de dépôt, du côté de la face 103T du substrat 103, d'une couche en un matériau à changement de phase 215 et d'une couche électriquement conductrice 217. Le plan AA de la figure 2G est sensiblement orthogonal au plan BB de la figure 2F.

Dans l'exemple représenté, seules des parties de la couche isolante 213 situées à l'intérieur des tranchées 207 subsistent à l'issue de l'étape d'amincissement, les parties de la couche isolante 213 situées à l'aplomb des parties des couches isolantes 203 et 205 étant totalement éliminées. En outre, dans cet exemple, l'amincissement de la couche isolante 213 est effectué de sorte à réduire l'épaisseur de la couche isolante 205 et la hauteur des parties des couches 209 et 211 subsistant à l'issue de l'étape de gravure anisotrope. Dans l'exemple illustré, chaque partie de la couche 209 est séparée de la partie de la couche 213 située en vis-à-vis par une épaisseur de matériau de la couche 211 supérieure ou égale à environ 20 nm.

Dans l'exemple représenté, la couche en matériau à changement de phase 215 revêt les faces supérieures des parties des couches 205, 209, 211 et 213 après amincissement. Dans cet exemple, la couche conductrice 217 revêt la face supérieure de la couche en matériau à changement de phase 215. Les compositions de la couche en matériau à changement de phase 215 et de la couche conductrice 217 sont par exemple identiques ou analogues respectivement aux compositions des régions 111 et 113 des cellules mémoire 101 du dispositif 100.

À titre d'exemple, la couche en matériau à changement de phase 215 présente une épaisseur comprise entre 20 nm et 100 nm, par exemple égale à environ 50 nm, et la couche conductrice 217 présente une épaisseur comprise entre 10 nm et 100 nm, par exemple égale à environ 50 nm.

Dans l'exemple représenté, les éléments de reprise de contact 105 et les parties de la couche conductrice 217 forment des électrodes de conduction de la cellule 201.

La figure 2H et la figure 2I sont des vues en coupe, respectivement selon le plan AA de la figure 2I et selon le plan BB de la figure 2H, illustrant une structure obtenue à l'issue d'une étape de formation de tranchées 219 et 221 puis de dépôt d'une couche d'encapsulation 223 du côté de la face 103T du substrat 103. Le plan AA de la figure 2I est sensiblement orthogonal au plan BB de la figure 2H.

Dans l'exemple représenté, les tranchées 219 et 221 s'étendent verticalement dans la structure, depuis la face supérieure de la couche 217, jusqu'à la face 103T du substrat 103. À titre de variante, les tranchées 219 peuvent être omises.

Les tranchées 219 sont par exemple sensiblement parallèles entre elles et s'étendent le long d'une direction sensiblement orthogonale au plan de la figure 2H. Les tranchées 219 séparent latéralement les cellules mémoire 201 faisant partie d'une même ligne de mot du dispositif mémoire 200. En outre, les tranchées 221 sont sensiblement parallèles entre elles et s'étendent le long d'une direction sensiblement orthogonale au plan de la figure 2I. Les tranchées 221 séparent latéralement les cellules mémoire 201 faisant partie d'une même ligne de bit du dispositif mémoire 200.

À titre d'exemple, les tranchées 219 et 221 sont formées par photolithographie puis gravure.

À l'issue de l'étape de formation des tranchées 219 et 221, l'élément chauffant et la région en matériau à changement de phase de chaque cellule mémoire 201 sont électriquement isolés par rapport aux éléments chauffants et aux régions en matériau à changement de phase des cellules mémoire 201 voisines.

Dans l'exemple représenté, la couche d'encapsulation 223 revêt la structure comprenant les parties des couches isolantes 203, 205 et 213, les parties de la couche en matériau à changement de phase 215 et de la couche électriquement conductrice 217 de chaque cellule mémoire 201. La couche d'encapsulation 223 revêt plus précisément toutes les faces latérales des parties des couches isolantes 203, 205 et 213, toutes les faces latérales des parties de la couche en matériau à changement de phase 215 et toutes les faces latérales et la face supérieure des parties de la couche conductrice 217, ainsi que les faces latérales de la partie en L de la couche 209 parallèles au plan de la figure 2H, non revêtues par les couches isolantes 203, 205 et 213. La couche d'encapsulation 223 peut en outre se prolonger entre les cellules mémoire 201, comme dans l'exemple illustré en figures 2H et 2I. Dans cet exemple, la couche 223 revêt plus particulièrement des parties de la face 103T du substrat 103 qui ne sont revêtues ni par les parties des couches isolantes 203 et 213, ni par l'élément chauffant 209.

Bien que cela n'ait pas été illustré, le dispositif mémoire 200 peut en outre comporter des éléments de sélection, par exemple des transistors MOS, situés du côté d'une face du substrat 103 opposée à la face 103T comme exposé précédemment en relation avec les figures 1A et 1B pour le dispositif mémoire 100. De manière générale, le dispositif mémoire 200 présente par exemple un fonctionnement identique ou analogue au dispositif 100 des figures 1A et 1B.

Un avantage du dispositif mémoire 200 des figures 2H et 2I tient au fait que la couche 203 permet d'obtenir une meilleure isolation thermique de la cellule mémoire 201, donc une distribution de chaleur plus uniforme dans le matériau à changement de phase de la couche 215, notamment par rapport à la cellule mémoire 101. Il en résulte que l'énergie électrique requise pour échauffer le matériau à changement de phase est plus faible dans le cas du dispositif mémoire 200 que dans le cas du dispositif mémoire 100. De façon avantageuse, cela permet au dispositif mémoire 200 intégrant les cellules 201 de présenter une consommation énergétique moindre que le dispositif mémoire 100 intégrant les cellules 101.

Par ailleurs, un avantage du procédé de fabrication du dispositif mémoire 200 exposé ci-dessus en relation avec les figures 2A à 2I tient au fait qu'il permet d'interposer la couche isolante 205 entre la couche 203 et la couche en matériau à changement de phase 215. La couche isolante 205 permet avantageusement de stabiliser chimiquement la couche 203 lors du chauffage de la couche en matériau à changement de phase 215 pendant les opérations de programmation de la cellule mémoire 201. Plus particulièrement, ceci permet que le matériau de la couche 203 ne soit pas en contact avec le matériau de la couche 215 au voisinage immédiat de l'élément chauffant 209, et ainsi d'éviter des réactions chimiques indésirables entre le matériau de la couche 203 et le matériau de la couche 215 lors du chauffage. Ceci permet d'utiliser, pour la couche 203, des matériaux plus variés, et notamment présentant un meilleur coefficient d'isolation thermique, que les matériaux pouvant être mis en contact direct avec la couche 215 au voisinage immédiat de l'élément chauffant 209.

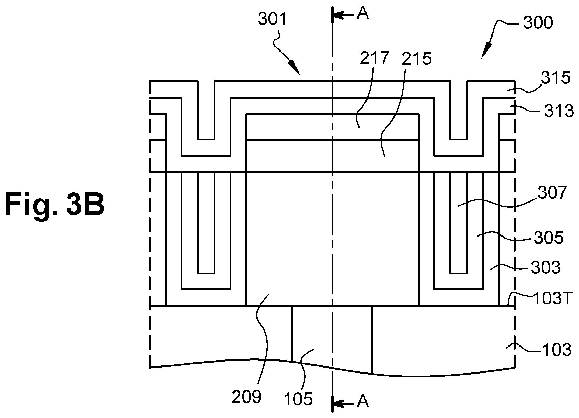

Les figure 3A et figure 3B sont des vues en coupe, respectivement selon le plan AA de la figure 3B et selon le plan BB de la figure 3A, illustrant, de façon schématique et partielle, un dispositif mémoire 300 comprenant des cellules mémoire 301 à base d'un matériau à changement de phase selon un mode de réalisation. Le plan AA de la figure 3B est sensiblement orthogonal au plan BB de la figure 3A.

Bien que les figures 3A et 3B illustrent un exemple dans lequel l'empilement constitué par les couches 203 et 205 présente des dimensions latérales sensiblement identiques à celles de l'empilement constitué par les couches 215 et 217, l'empilement constitué par les couches 215 et 217 peut, à titre de variante, présenter des dimensions latérales différentes de celles de l'empilement constitué par les couches 203 et 205.

Le dispositif 300 des figures 3A et 3B comprend des éléments communs avec le dispositif 200 des figures 2H et 2I. Ces éléments communs ne seront pas détaillés à nouveau ci-après. Le dispositif 300 des figures 3A et 3B diffère du dispositif 200 des figures 2H et 2I en ce que le dispositif 300 comprend des cellules mémoire 301 comportant plusieurs couches d'encapsulation présentant différentes densités.

Dans l'exemple représenté, les cellules mémoire 301 comprennent une couche d'encapsulation 303 revêtant la structure comprenant les parties des couches isolantes 203, 205 et 213 de chaque cellule mémoire 301. La couche d'encapsulation 303 revêt plus précisément toutes les faces latérales des parties des couches isolantes 203, 205 et 213, ainsi que les faces latérales de la partie en L de la couche 209 parallèles au plan de la figure 3A, non revêtues par les couches isolantes 203, 205 et 213. Dans cet exemple, pour chaque cellule mémoire 301, la couche d'encapsulation 303 revêt la couche isolante 213, revêtant une partie de la couche isolante 211 située à l'intérieur du L formé par l'élément chauffant 209, et les faces latérales de l'élément chauffant 209 non revêtues par les couches isolantes 203 et 213. La couche d'encapsulation 303 peut en outre se prolonger entre les cellules mémoire 301, comme dans l'exemple illustré en figures 3A et 3B. Dans cet exemple, la couche 303 revêt plus particulièrement des parties de la face 103T du substrat 103 qui ne sont revêtues ni par les parties des couches isolantes 203 et 213, ni par l'élément chauffant 209.

Selon un mode de réalisation, la couche d'encapsulation 303 est revêtue d'au moins une autre couche d'encapsulation 305 (une seule autre couche d'encapsulation 305, dans l'exemple représenté) en un matériau présentant une densité inférieure à celle de la couche 303. Les couches d'encapsulation 303 et 305 sont par exemple déposées à l'issue d'une étape de structuration des cellules mémoire 301. À titre d'exemple, la couche 305 est en le même matériau que la couche 303, par exemple du carbure de silicium, mais présente une densité inférieure à celle de la couche 303. À titre de variante, la couche 305 est en un matériau différent du matériau de la couche 303. À titre d'exemple, les couches d'encapsulation 303 et 305 sont respectivement en nitrure de silicium (SiN) et en carbure de silicium (SiC).

Dans l'exemple représenté, un matériau diélectrique de remplissage 307 revêt la couche d'encapsulation 305 et comble les espaces libres entre les cellules mémoire 301. Dans cet exemple, le matériau de remplissage 307 affleure la face supérieure des couches isolantes 205 et 213.

Dans l'exemple illustré en figures 3A et 3B, les cellules mémoire 301 comprennent une autre couche d'encapsulation 313 revêtant la structure comprenant les parties de la couche en matériau à changement de phase 215 et de la couche électriquement conductrice 217 de chaque cellule mémoire 301. La couche d'encapsulation 223 revêt plus précisément toutes les faces latérales des parties de la couche en matériau à changement de phase 215 et toutes les faces latérales et la face supérieure des parties de la couche conductrice 217. La couche d'encapsulation 313 peut en outre se prolonger entre les cellules mémoire 301, comme dans l'exemple illustré en figures 3A et 3B. Dans cet exemple, la couche 313 revêt plus particulièrement les faces supérieures des couches d'encapsulation 303 et 305 et du matériau de remplissage 307.

Dans l'exemple représenté, la couche d'encapsulation 313 est revêtue d'au moins une autre couche d'encapsulation 315 (une seule autre couche d'encapsulation 315, dans l'exemple représenté) en un matériau présentant une densité inférieure à celle de la couche 313. Dans cet exemple, la couche en matériau à changement de phase 215 est recouverte d'une bicouche constituée des couches d'encapsulation 313 et 315. Cela permet avantageusement d'obtenir une meilleure isolation thermique. À titre d'exemple, la couche 315 est en le même matériau que la couche 313, par exemple du carbure de silicium, mais présente une densité inférieure à celle de la couche 313. À titre de variante, la couche 315 est en un matériau différent du matériau de la couche 313. À titre d'exemple, les couches d'encapsulation 313 et 315 sont respectivement en les mêmes matériaux et présentent respectivement les mêmes densités que les couches d'encapsulation 303 et 305.

Le dispositif 300 est par exemple obtenu par un procédé de fabrication analogue à celui du dispositif 200 décrit ci-dessus en relation avec les figures 2A à 2I. À titre d'exemple, les éléments chauffants 209 des cellules mémoire 301 sont individualisés après le dépôt de la couche isolante 213, puis les couches d'encapsulation 303 et 305 et le matériau de remplissage 307 sont déposés sur la structure du côté de la face supérieure 103T du substrat 103. On amincit ensuite les couches d'encapsulation 303 et 305, le matériau de remplissage 307 et la couche isolante 213 jusqu'à atteindre la couche isolante 205, la couche 205 pouvant également être amincie lors de cette étape. La couche en matériau à changement de phase 215 et la couche conductrice 217 peuvent ensuite être déposées puis structurées, par exemple par photolithographie puis gravure, de sorte à individualiser la couche en matériau à changement de phase 215 et la couche conductrice 217 des cellules mémoire 301. Enfin, les couches d'encapsulation 313 et 315 peuvent être successivement déposées sur la structure du côté de la face 103T du substrat 103.

Bien que l'on ait décrit en relation avec les figures 3A et 3B un exemple de réalisation dans lequel les couches d'encapsulation 303 et 305 et le matériau de remplissage 307 sont déposés avant la couche en matériau à changement de phase 215, on pourrait à titre de variante prévoir de déposer les couches d'encapsulation 303 et 305 après la couche en matériau à changement de phase 215, par exemple après le dépôt de la couche 217. Dans ce cas, les couches d'encapsulation 313 et 315 peuvent être omises, l'empilement des couches d'encapsulation 303 et 305 remplaçant alors la couche d'encapsulation 223 des figures 2H et 2I.

Un avantage du dispositif mémoire 300 des figures 3A et 3B tient au fait que l'empilement des couches d'encapsulation 303 et 305 permet d'obtenir une meilleure isolation thermique de la cellule mémoire 301, donc une distribution de chaleur plus uniforme dans le matériau à changement de phase de la couche 215, notamment par rapport à la cellule mémoire 101. Il en résulte que l'énergie électrique requise pour échauffer le matériau à changement de phase est plus faible dans le cas du dispositif mémoire 300 que dans le cas du dispositif mémoire 100. De façon avantageuse, cela permet au dispositif mémoire 300 intégrant les cellules 301 de présenter une consommation énergétique moindre que le dispositif mémoire 100 intégrant les cellules 101.

Par ailleurs, un avantage du dispositif mémoire 300 des figures 3A et 3B est que la couche d'encapsulation 303, respectivement 313, de plus forte densité, s'interpose entre la couche 305, respectivement 315, de plus faible densité, et la couche 215 en le matériau à changement de phase au voisinage du point le plus chaud de la couche 215, c'est à dire au voisinage de la surface de la couche 215 en contact avec l'élément chauffant 209. La couche d'encapsulation 303, respectivement 313 permet ainsi de stabiliser chimiquement la couche 305, respectivement 315 lors du chauffage de la couche en matériau à changement de phase 215 pendant les opérations de programmation de la cellule mémoire 301. Plus particulièrement, ceci permet d'éviter des interactions, par exemple des réactions chimiques indésirables, entre le matériau de la couche 305, respectivement 315 et le matériau de la couche 215 lors du chauffage.

Bien que des empilements constitués chacun de seulement deux couches d'encapsulation 303, 313 et 305, 315 aient été illustrés, il serait possible, à titre de variante :
- de revêtir la couche d'encapsulation 305, respectivement 315, d'une autre couche d'encapsulation présentant une densité inférieure à celle de la couche d'encapsulation 305, respectivement 315, par exemple une couche en carbure de silicium moins dense que la couche 305, respectivement 315 ;
- de revêtir la couche d'encapsulation 305, respectivement 315, d'une autre couche d'encapsulation présentant une densité supérieure à celle de la couche d'encapsulation 305, respectivement 315, par exemple une couche en nitrure de silicium ou une couche en carbure de silicium plus dense que la couche 305, respectivement 315 ;
- de revêtir la couche d'encapsulation 305, respectivement 315, d'un autre empilement comprenant une alternance de couches d'encapsulation du type des couches 303 et 305, respectivement 313 et 315, et pouvant se terminer par une couche présentant une densité sensiblement égale à celle de la couche d'encapsulation 303, respectivement 313, par exemple une couche en nitrure de silicium ; ou
- de revêtir la couche d'encapsulation 305, respectivement 315, d'un autre empilement de couches d'encapsulation, en des matériaux différents ou en un même matériau, présentant des densités inférieures à celles de la couche 305, respectivement 315, et décroissantes à mesure que l'on s'éloigne de la couche 305, respectivement 315, par exemple de façon à obtenir une couche d'encapsulation en unique matériau, par exemple du carbure de silicium, présentant un gradient de densité, ladite couche d'encapsulation étant revêtue d'une couche externe présentant une forte densité, sensiblement égale à celle de la couche d'encapsulation 303, respectivement 313, par exemple une couche en nitrure de silicium.

Dans le cas où la couche d'encapsulation 305, respectivement 315, est revêtue d'une couche d'encapsulation additionnelle présentant une densité supérieure à celle de la couche d'encapsulation 305, respectivement 315, cela permet avantageusement de protéger la couche 305, respectivement 315, contre l'oxydation. Dans ce cas, la couche 303, respectivement 313, permet de bloquer l'interaction entre le matériau à changement de phase de la couche 215 et la couche 305, respectivement 315, et la couche d'encapsulation additionnelle permet de protéger la couche 305, respectivement 315, contre l'oxydation.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le mode de réalisation du dispositif mémoire 300 des figures 3A et 3B est transposable par la personne du métier au dispositif mémoire 100 des figures 1A et 1B.

Enfin, la mise en œuvre pratique des modes de réalisation et variantes décrits est à la portée de la personne du métier à partir des indications fonctionnelles données ci-dessus. En particulier, la personne du métier est capable de choisir les techniques de dépôt et de gravure à mettre en œuvre pour réaliser les différentes couches et régions des dispositifs décrits.

## Revendications

1. Cellule mémoire à changement de phase (301) comprenant :
- une première couche en un matériau à changement de phase (215) ;
- un élément chauffant (209) situé sous la première couche (215) ;
- une deuxième couche isolante (203) revêtant un flanc de l'élément chauffant (209) ; et
- un premier empilement comportant une troisième couche d'encapsulation (303) revêtant les faces latérales de la deuxième couche (203), une quatrième couche d'encapsulation (305) revêtant la troisième couche (303) et étant en un matériau présentant une densité inférieure à celle du matériau de la troisième couche (303)
**caractérisé en ce que** le premier empilement comprend en outre une cinquième couche (307) d'encapsulation revêtant la quatrième couche et étant en un matériau présentant une densité supérieure à celle du matériau de la quatrième couche.

2. Cellule selon la revendication 1, comprenant en outre une première électrode de conduction (105) située sous et en contact avec une face de l'élément chauffant (209) opposée à la première couche (215) et une deuxième électrode de conduction (217) située sur et en contact avec une face de la première couche (215) opposée à l'élément chauffant (209).

3. Cellule selon la revendication 2, comprenant en outre un deuxième empilement comportant une sixième couche d'encapsulation (313) revêtant les faces latérales de la première couche (215) et de la deuxième électrode de conduction (217) et une septième couche d'encapsulation (315) revêtant la sixième couche (313) et présentant une densité inférieure à celle de la sixième couche (313).

4. Cellule selon la revendication 1, 2 ou 3, comprenant en outre une huitième couche (205) interposée entre les première et deuxième couches (215, 203) et présentant une densité supérieure à celle de la deuxième couche (203), la deuxième couche (203) étant en carbure de silicium ou en carbonitrure de silicium.

5. Cellule selon la revendication 4, dans laquelle la huitième couche (205) est en carbure de silicium, en nitrure de silicium ou en carbonitrure de silicium et présente une densité supérieure à celle de la deuxième couche (203).

6. Cellule selon la revendication 4, dans laquelle la huitième couche (205) est en nitrure de germanium, en nitrure de carbone ou en carbone.

7. Procédé de fabrication d'une cellule mémoire à changement de phase (301) comprenant les étapes successives suivantes :
a) déposer, sur un substrat (103), au moins une première couche thermiquement isolante (203) ;
b) former, dans une tranchée traversant ladite au moins une première couche (203), un élément chauffant (209) dont un flanc est revêtu par ladite au moins une première couche (203) ; et
c) former un premier empilement comportant une deuxième couche d'encapsulation (303) revêtant les faces latérales de ladite au moins une première couche (203), une troisième couche d'encapsulation (305) revêtant la deuxième couche (303) **et étant en un matériau présentant une densité inférieure à celle du matériau de la deuxième couche (303), et une quatrième couche** (307) **d'encapsulation revêtant la troisième couche d'encapsulation et étant en un matériau présentant une densité supérieure à celle du matériau de la troisième couche,**
**le procédé comprenant en outre une étape de formation d'une cinquième couche en un matériau à changement de phase (215).**

## Patentansprüche

1. Phasenwechsel-Speicherzelle (301), die Folgendes aufweist:
- eine erste Schicht, die aus einem Phasenwechselmaterial (215) besteht;
- ein Heizelement (209), das sich unter der ersten Schicht (215) befindet;
- eine zweite Isolierschicht (203), die eine Seite des Heizelements (209) bedeckt; und
- einen ersten Stapel, der eine dritte Verkapselungsschicht (303) aufweist, die die Seitenflächen der zweiten Schicht (203) bedeckt, und eine vierte Verkapselungsschicht (305), die die dritte Schicht (303) bedeckt und die aus einem Material mit einer geringeren Dichte als jener des Materials der dritten Schicht besteht (303) besteht;
**dadurch gekennzeichnet, dass** der erste Stapel ferner eine fünfte Verkapselungsschicht (307) aufweist, die die vierte Schicht bedeckt und die aus einem Material mit einer höheren Dichte als jener des Materials der vierten Schicht besteht.

2. Zelle nach Anspruch 1, die ferner eine erste Leitungselektrode (105) aufweist, die unter einer und in Kontakt mit der der ersten Schicht (215) gegenüberliegenden Seitenfläche des Heizelements (209) angeordnet ist, und eine zweite Leitungselektrode (217), die auf einer und in Kontakt mit der dem Heizelement (209) gegenüberliegenden Seitenfläche der ersten Schicht (215) angeordnet ist.

3. Zelle nach Anspruch 2, die ferner einen dritten Stapel aufweist, der eine sechste Verkapselungsschicht (313) aufweist, die die Seitenflächen der ersten Schicht (215) und der zweiten Leitungselektrode (217) bedeckt, und eine siebte Verkapselungsschicht (315), die die sechste Schicht (313) bedeckt und eine geringere Dichte als die sechste Schicht (313) hat.

4. Zelle nach Anspruch 1, 2 oder 3, die ferner eine achte Schicht (205) aufweist, die zwischen der ersten und der zweiten Schicht (215, 203) angeordnet ist und die eine höhere Dichte als jene der zweiten Schicht (203) aufweist, wobei die zweite Schicht (203) aus Siliziumkarbid oder Siliziumcarbonitrid besteht.

5. Zelle nach Anspruch 4, wobei die achte Schicht (205) aus Siliziumkarbid, Siliziumnitrid oder Siliziumcarbonitrid besteht und eine höhere Dichte als jene der zweiten Schicht (203) aufweist.

6. Zelle nach Anspruch 4, wobei die achte Schicht (205) aus Germaniumnitrid, Kohlenstoffnitrid oder Kohlenstoff besteht.

7. Verfahren zur Herstellung einer Phasenwechsel-Speicherzelle (301), das die folgenden aufeinanderfolgenden Schritte aufweist:
a) Aufbringen mindestens einer ersten thermisch isolierenden Schicht (203) auf ein Substrat (103);
b) Bilden eines Heizelements (209) in einer Rinne, die sich durch die mindestens eine erste Schicht (203) erstreckt, wobei eine Seite des Heizelements mit der mindestens einen ersten Schicht (203) beschichtet ist; und
c) Bilden eines ersten Stapels, der eine zweite Verkapselungsschicht (303) aufweist, die die Seitenflächen der mindestens einen ersten Schicht (203) bedeckt, eine dritte Verkapselungsschicht (305), die die zweite Schicht (303) bedeckt und aus einem Material mit einer geringeren Dichte als jene des Materials der zweiten Schicht (303) besteht, und einer vierten Einkapselungsschicht (307), die die dritte Einkapselungsschicht bedeckt und aus einem Material mit einer höheren Dichte als jene des Materials der dritten Schicht besteht,
wobei das Verfahren ferner einen Schritt zum Bilden einer fünften Schicht aus einem Phasenwechselmaterial (215) aufweist.

## Claims

1. Phase change memory cell (301) comprising:
- a first layer in a phase change material (215);
- a heating element (209) located under the first layer (215);
- a second insulating layer (203) coating a side of the heating element (209); and
- a first stack comprising a third encapsulation layer (303) coating the side faces of the second layer (203), a fourth encapsulation layer (305) coating the third layer (303) and being in a material having a density lower than that of the material of the third layer (303)
**characterized in that** the first stack further comprises a fifth encapsulation layer (307) coating the fourth layer and being in a material having a density higher than that of the material of the fourth layer.

2. Cell according to claim 1, further comprising a first conduction electrode (105) located under and in contact with one face of the heating element (209) opposite to the first layer (215) and a second conduction electrode (217) located on and in contact with one face of the first layer (215) opposite to the heating element (209).

3. Cell according to claim 2, further comprising a third stack comprising a sixth encapsulation layer (313) coating the side faces of the first layer (215) and of the second conduction electrode (217) and a seventh encapsulation layer (315) coating the sixth layer (313) and having a density lower than that of the sixth layer (313).

4. Cell according to claim 1, 2 or 3, further comprising an eighth layer (205) interposed between the first and second layers (215, 203) and having a density higher than that of the second layer (203), the second layer (203) being in silicon carbide or silicon carbonitride.

5. Cell according to claim 4, wherein the eighth layer (205) is in silicon carbide, in silicon nitride or in silicon carbonitride and has a density higher than that of the second layer (203).

6. Cell according to claim 4, wherein the eighth layer (205) is in germanium nitride, in carbon nitride or in carbon.

7. Method of manufacturing of a phase change memory cell (301) comprising the following successive steps:
a) depositing, on a substrate (103), at least one first thermally insulating layer (203);
b) forming, in a trench extending through said at least one first layer (203), a heating element (209) having a side coated with said at least one first layer (203); and
c) forming a first stack comprising a second encapsulation layer (303) coating the side faces of said at least one first layer (203), a third encapsulation layer (305) coating the second layer (303) and being in a material having a density lower than that of the material of the second layer (303), and a fourth encapsulation layer (307) coating the third encapsulation layer and being in a material having a density higher than that of the material of the third layer,
the method further comprising a step of forming a fifth layer in a phase change material (215).
